# EUROPEAN PATENT APPLICATION

(11) **EP 4 325 404 A1**
(43) Date of publication of application: **21.02.2024**
(21) Application number: 23182987.0
(22) Date of filing: 03.07.2023
(51) Int. Cl.: G06Q 10/0631, G06F 30/13, G06N 5/025, G06N 20/00, G06Q 50/08

(54) **AUTOMATIC INFORMATION SHARING WITHIN A PROJECT**

(30) Priority: 17.08.2022 FI 20225732
(71) Applicant: Trimble Solutions Corporation, 02600 Espoo (FI)
(72) Inventor: Suomi, Jukka, 02600 Espoo (FI); Wessman, Ragnar, 02600 Espoo (FI); Higgins, Grant, 02600 Espoo (FI); Tronsmoen, Erling, 02600 Espoo (FI); Rousu, Ville, 02600 Espoo (FI)
(74) Representative: Kilburn & Strode LLP

(57) **Abstract**

Mechanisms to facilitate task related information sharing between different parties of a project are disclosed. A task (220-1) will have one or more dependent tasks (220b-2, 220c-2). To share task related information of a first task, mutual access rights are provided per a pair of the first task (220a-2) and a dependent task (220-1). Thanks to the mutual access rights, a party responsible for the dependent task will have access rights to task related information of the first task and a party responsible for the first task will have access rights to task related information of the dependent task.

## Description

### TECHNICAL FIELD

Various examples relate to information sharing between different parties of a project.

### BACKGROUND

The development of data processing systems, computer and computer applications has transformed different processes into computerized processes. For example, there are different modeling applications, planning applications and project control applications. When there is a project involving, possibly at different or overlapping times, different stakeholders, or parties, performing different tasks using different applications, there is a need for an easy to use solution to share information.

### SUMMARY

An object of the present invention is to provide a mechanism to automatically share task related information of a project between different responsible parties of the project. The object of the invention is achieved by methods, a computer program product and an apparatus which are characterized by what is stated in the independent claims. The preferred embodiments are disclosed in the dependent claims.

### BRIEF DESCRIPTION OF DRAWINGS

Embodiments are described below, by way of example only, with reference to the accompanying drawings, in which
Figure 1 shows a simplified architecture of an example of a system and a schematic block diagram of apparatuses;
Figure 2 illustrates an example view of a piece of workflow and its dependent tasks;
Figures 3 to 6 are flow charts illustrating example functionalities;
Figures 7 to 11 illustrate examples of information sharing; and
Figure 12 is a schematic block diagram.

### DETAILED DESCRIPTION OF SOME EMBODIMENTS

The following embodiments are examples. Although the specification may refer to "an", "one", or "some" embodiment(s) in several locations, this does not necessarily mean that each such reference is to the same embodiment(s), or that the feature only applies to a single embodiment. Single features of different embodiments may also be combined to provide other embodiments. Furthermore, words "comprising" and "including" should be understood as not limiting the described embodiments to consist of only those features that have been mentioned and such embodiments may also contain features/structures that have not been specifically mentioned. Further, although terms including ordinal numbers, such as "first", "second", etc., may be used for describing various elements, the elements are not restricted by the terms. The terms are used merely for the purpose of distinguishing an element from other elements. For example, a first task could be termed a second task, and similarly, a second task could be also termed a first task without departing from the scope of the present disclosure.

The present invention is applicable to any apparatus, system or equipment that is configured or configurable to support information sharing between different parties, possibly using different planning or scheduling applications. Examples of such applications include different planning, controlling and/or scheduling applications, computer aided design applications and computer aided modeling applications, such as different Building Information Modeling (BIM) applications. Current BIM applications are used to plan, design, construct, operate and maintain diverse construction products (physical structures), such as different buildings, roads, bridges, ports, tunnels, etc.

Various programming techniques, storage of data in memory and manners of scheduling tasks and/or modeling end results, for example real world articles, and implementing databases develop constantly. This may require extra changes in the invention. Consequently, all terms and expressions should be interpreted broadly, and they are intended to describe, not to restrict, the invention.

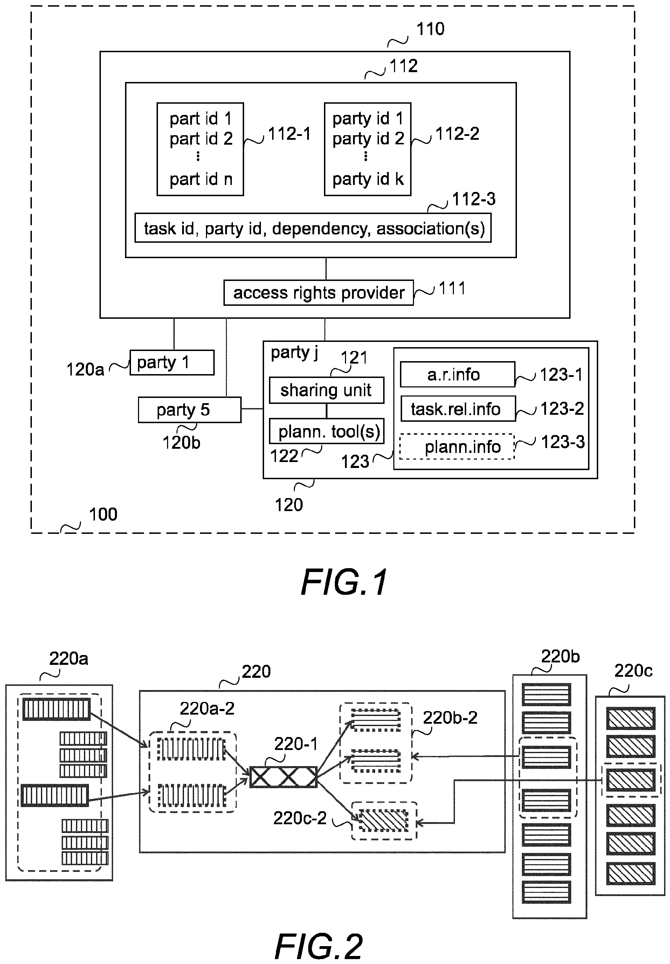

Figure 1 illustrates a high level simplified architecture of a system 100 for information sharing between two or more responsible parties, depicted in Figure 1 by corresponding apparatuses (equipment) 120, 120a, 120b of the responsible parties.

The system 100 illustrated in Figure 1 comprises one or more entities 110 (one is shown in Figure 1) that are configured to maintain at least high level information for information sharing within projects and to provide access rights, as will be described in detail below. For that purpose the entity 110 may comprise a unit 111, for example an apparatus 111, or any computing device, or a circuitry, configured to operate or act at least as an access rights provider, connectable to one or more data storages 112 (one is shown in Figure 1). The entity 110 may be a technical platform providing hardware and/or application over which one or more services, including the herein described access rights provisioning and maintaining at least the shared information 112-1, 112-2, 112-3, may be run, or a server, like a cloud server or a grid server.

The data storage 112 stores, per a project, or maintains for a project, at least shared model information 112-1 of an end result of the project, shared information 112-2 of responsible parties involved, and a shared workflow 112-3.

The shared model information 112-1 comprises at least, per a part, a part identifier, which is unique within the project. A part represents a piece for the end result in a model of the end result. For example, using a finalized building as an example of the end result, a piece may be a whole floor, a slab, reinforcement in the slab, etc. In another example, an end result may be a paper roll, and a piece may be a tree, a pile of lumber, etc. The shared model information 112-1 may comprise only a portion of model information modeling the end result. The shared model information comprises at least model information used by responsible parties at least to map the shared model information with their tasks and/or own model information. A part identifier covers herein also information based on which different applications can conclude that the piece is the same. For example, based on 3D location information, a floor in an architect's model can be concluded to be the same as a set of slabs in an implementation plan.

The shared information 112-2 of responsible parties may comprise, per a party, identification information of the party, and/or additional information, like role of the responsible party, address information, link to one or more data resources, etc.

The shared workflow 112-3 comprises a plurality of tasks. A task represents a piece of work to be done or undertaken. The tasks are in the shared workflow in an order in which a preceding task has to be completed before the piece of work the task represents can start. It should be appreciated that a preceding task covers herein any of the plurality of preceding tasks, or at least immediately preceding task(s). However, the information for the shared workflow may be stored in any order. The information, i.e. data stored, for the shared workflow 112-3 comprises, per a task, at least a task identifier, identification information of the responsible party, or at least an indication of a party responsible for the task, dependency information indicating one or more dependent tasks and possible association information. The task identifier is unique at least within the project. The dependency information indicates, for example using task identifiers, one or more dependent tasks, a dependent task being either a preceding task or a following task. The association information may associate the task with one or more parts, for example by means of one or more part identifiers. The association information may associate the task with a shared resource in the project. The association information may associate the task with a shared location. The task may be associated with any combination of the above listed association information. For example, a task may be painting a wall, having a part identifier, and associated with a shared resource, for example a ladder, and a shared location, for example a floor area required by the ladder when the wall is painted, i.e. work is being done. Further examples of a shared resource include a crane, a forklift, Further examples of a shared location include unloading areas, temporary/intermediate storage areas, etc.

The order of the tasks, i.e. the shared workflow, may be determined by a user inputting the workflow, either independently or with a help of a project planning application, which may use artificial intelligence tools, like machine learning. Any of the shared information may be updated while the project is going on. Further, the shared workflow may have parallel sub-workflows. Using the building as an example, architectural modeling and structural modeling may overlap as well as work performed at the construction site. However, different tasks in construction have a logical order, for example before a column in a third floor can be erected, the first and second floors have to be ready enough and the column has to be fabricated according to the structural model with details and transported to the site. Yet, during that detailing of the sixth floor may take place.

It should be appreciated that a task may be a sub-project, i.e. covering two or more sub-tasks forming the task, and a sub-project may have its own responsible parties, like subcontractors responsible for the party who is responsible for the task. In other words, the structure may be hierarchical, and the hierarchy may be at least partly hidden from the other responsible parties on the same hierarchy level in the project.

An apparatus 120, 120a, 120b of a party may be any computing device that can be configured to perform at least part of the functionalities described below relating to a party or parties. For that purpose, as illustrated with the apparatus 120, the apparatus 120 comprises a sharing unit 121. The sharing unit may be configured to provide the apparatus, i.e. the party, per a project, access at least to the shared model information 112-1, and to the shared workflow 112-3 for the project. The sharing unit may be configured to maintain access rights information 123-1 and task related information 123-2. The sharing unit 121 may be part of a planning tool 122, for example a modeling application, or an add-in or a plug-in to the planning tool 122, or to planning tools 122 if there are two or more different planning tools. The apparatus 110 further comprises different interfaces (not illustrated in Figure 1), for example one or more user interfaces and one or more interfaces to share information, as will be described in more detail below. A non-limiting list of examples of apparatuses 110 includes a user terminal or a workstation, such as a laptop, a smartphone, a personal computer, a tablet computer, a field device, a virtual reality device, augmented reality (AR) interface device, a web client, or a server, like a cloud server or a grid server.

In the illustrated example, the apparatus 120 comprises a data storage 123, which comprises for the information sharing, the access rights information (a.r.info) 123-1 and the task related information 123-2. The data storage 123 may comprise other information 123-3, for example planning information, relating to the project and/or to other projects of the party, the other information not being accessible by other parties of the project.

The access rights information 123-1 comprises information on access rights to other parties task related information. The access rights information 123-1 may comprise information on other parties having access rights to task related information 123-2, or to a portion of the task related information 123-2 to be used, for example by the sharing unit, to allow the other party to access the portion of the task related information, or the task related information. The access rights are preferably read-only access rights, but a party may also provide other access rights, which may be indicated in the access rights information. It should be appreciated that any known or future method relating to access rights may be used. Generally speaking, the access rights to a piece of data means a right (a permission) to at least obtain the piece of data, for example by retrieving the piece of data from a specific location.

The task related information of the party 123-2 is accessible by one or more other parties in the project. The task related information 123-2 comprises, per a task, at least one of timing related information, location related information and shared resource related information. The timing related information indicates preferably at least planned starting time and/or ending time of the task. The location related information of a task defines at least one of a space defined based on a physical size of a part associated with the task or the space defined based on the physical size added with extra space required for the work to be performed. The location related information may also define a physical location. The shared resource related information may indicate one or more shared resources needed for the task. Examples of the shared resources are given above. The task related information may comprise also any other information the party is willing to share. In other words, the party of the project may determine how much other information than the timing related information, location related information and/or shared resource related information to share to other parties of the project. For example, a detailed description of what a task constitutes, for example work relating to the task, such as cutting trees or leveling a wall by plastering and sanding, may be part of the task related shared information, or non-shared task related information. For example, the task related information comprises end result information of the piece of work. The task related information 123-2 may be part of the planning information 123-3, or a copy of the task related information. The copy may be stored in any data storage accessible by the responsible parties, for example to the data storage 112 in the entity 110. Regardless of the planning tool(s) 122 used, the sharing unit is configured to ensure that the task related information 123-2 has a data structure, which is common (same) used by responsible parties, to enable the information sharing between different applications.

The data storage 112 of the entity 110 and/or the data storage of 123 of a party may be any kind of conventional or future data repository, including distributed (federated) and centralized storing of data, managed by any suitable management system. Examples of distributed storing include a cloud-based storage in a cloud environment (which may be a public cloud, a community cloud, a private cloud, or a hybrid cloud, or a decentralized (non-hosted) cloud, for example), and a blockchain-based storage in a decentralized environment. Cloud storage services may be accessed through a co-located cloud computer service, a web service application programming interface (API) or by applications that utilize API, such as cloud desktop storage, a cloud storage gateway or Web-based content management systems. Data in blockchains may be accessed through a variety of applications, such as different metaverse applications, or through database interfaces. Further, the entity 110 and/or a party (apparatus 123) may comprise several servers with databases, which may be integrated to be visible to parties (apparatuses) as one database and one database server. However, the implementation of the data storage, the manner how data is stored, retrieved, accessed and updated, etc. are irrelevant to the invention, and hence there is no need to describe them in more detail herein.

In the following different example functionalities are described without describing steps relating to connection establishment(s) to data storages, for example, to access/retrieve or store data. In the examples, terms "entity" and "party" are used to cover corresponding apparatuses/equipments and users, for the sake of clarity. Further, it is assumed that applications, with the above described tools, are running to enable the functionality.

Figure 2 illustrates a simplified example of an internal view, or a local view, i.e. a view of a workflow of a party, which view can be generated (created) by using own information created by the planning tool and by using, by the sharing unit, access rights and thus obtained task related information of other parties. The view may be shown via one or more user interfaces. For the sake of clarity, the local view in Figure 2 is a scheduling view for one task in one project. Although not illustrated, it should be appreciated that the scheduling view may have plurality of tasks of the party, and the tasks may be tasks in different projects, and/or tasks in one project. In the illustrated example, internal dependencies of preceding and following tasks are not generated, and hence not illustrated. Further, the workflow only illustrates the order of the tasks in view of a responsible party, not illustrating planned timing. It should be appreciated that in other implementations internal dependencies of the preceding and following tasks may be determined and illustrated and/or the workflow may also indicate the planned timing.

Referring to Figure 2, it illustrates a scheduling view 220 of a responsible party for a task 220-1 in a project. Thanks to sharing task related information, which in the illustrated example is timing information, the scheduling view 220 also comprises task related timing information 220a-2, 220b-2, 220c-2 of other parties 220a, 220b, 220c in the project. The other parties are parties responsible for dependent tasks, and the project may have further parties. In the illustrated example, there are two tasks 220a-2 that have to be completed before work relating to the task 220-1 can start. When the task 220-1 is completed, work relating to tasks 220b-2 and task 220c-2 can start. The tasks 220b-2 may be intermediate, or assisting tasks, resulting that also the task 220c-2 is defined in the shared workflow as a dependent task for the task 220-1. More precisely, the internal workflow of tasks 220a-2, 220-1, 220b-2, 220c-2 is generated using the task 220-1, and information 220a-2, 220b-2, 220c-2 obtained using the access rights information. Dotted lines illustrate read-only information that the party whose internal workflow (or internal view of the workflow) is shown can only see. As can be seen, only a portion of scheduling information of the other parties is used and yet the required information obtained.

For example, the view 220 may be a prefabricator's view, wherein the task 220-1 illustrates fabrication of a part, the tasks 220a-2 illustrate detailing tasks of the part, the tasks 220b-2 illustrate transportation of the part to a construction site and the task 220c-2 illustrates erection of the part. In another example the view 220 may be a view of a party responsible for leveling of surfaces, the task 220-1 illustrates leveling surfaces in a room, the tasks 220a-2 illustrates erection of wall elements and erection of slabs forming a ceiling, the task 220b-2 illustrates painting of the ceiling and painting of the walls, and the task 220c-2 illustrates hardwood floor installation.

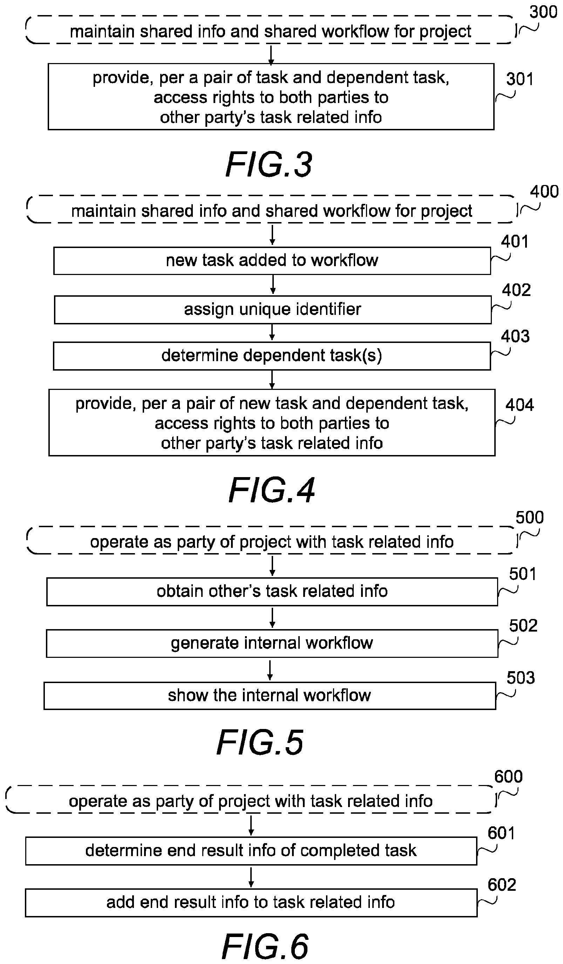

Figures 3 and 4 illustrate example functionalities of the entity maintaining the shared information, i.e. the shared model information and shared information of responsible parties, and the shared workflow.

Referring to Figure 3, while maintaining (step 300) the shared information for a project and a shared workflow for the project, access rights are provided in step 301 to a plurality of tasks, per a pair of a task and its dependent task, to both parties to task related information. More precisely, per a pair of a first task and a dependent task of the first task, a responsible party of the dependent task is provided with access rights to task related information of a responsible party of the first task, and to share the information by both parties, the responsible party of the first task is provided with access rights to task related information of the responsible party of the dependent task. Using the example of Figure 2, and the task 220-1, there will following pairs with corresponding access rights: a pair of the task 220-1 and the upper task in 220a-2, a pair of the task 220-1 and the lower task in 220a-2, a pair of the task 220-1 and the upper task in 220b-2, a pair of the task 220-1 and the lower task in 220b-2, and a pair of the task 220-1 and the task 220c-2.

Referring to Figure 4, while maintaining (step 400) the shared information for a project and a shared workflow for the project, it is detected that a new task, which is associated with information comprising at least one of a part identifier, a shared resource in the project and a shared location, is added in step 401 to the shared workflow. A task identifier, which is unique at least within the project, is assigned in step 402 to the new task. Further, using the information associated with the new task, information of the party adding the new task, the shared model information, the shared information of responsible parties involved and the shared workflow, one or more dependent tasks are determined in step 403 to the new task. Using the example of Figure 2, if the new task added is the task 220-1, the dependent tasks, assuming that they already exist, will be the tasks in 220a-2, the tasks in 220b-2 and the task 220c-2. Then access rights are provided in step 404, per a pair of the new task and its dependent task, to both parties to task related information. More precisely, per a pair of the new task and a dependent task of the new task, a responsible party of the dependent task is provided with access rights to task related information of the new task, and correspondingly, the responsible party of the new task is provided, per the pair of the new task and the dependent task, with access rights to task related information of the responsible party of the dependent task. Using the example of Figure 2, and the task 220-1, there will following pairs with corresponding access rights: a pair of the task 220-1 and the upper task in 220a-2, a pair of the task 220-1 and the lower task in 220a-2, a pair of the task 220-1 and the upper task in 220b-2, a pair of the task 220-1 and the lower task in 220b-2, and a pair of the task 220-1 and the task 220c-2.

Figures 5 and 6 illustrate example functionalities of a party. Even though in Figures 5 and 6 the functionality is described, for the sake of clarity of description, using one task of the party, it is a straightforward process for one skilled in the art to implement the examples to a plurality of tasks of the party.

Referring to Figure 5, it is assumed that the party operates (step 500) as a party responsible for a task in a project. Operating as the party responsible for the task includes that the party maintains task related information of the task, to which the entity maintaining the shared model information and the shared workflow provides access rights as described for example with Figures 3 and 4. Mutually, the party maintains access rights information to task related information of one or more other parties of one or more dependent tasks, the access rights being provided by the entity. Further, operating as the party responsible for the task means that the party has access at least to shared model information of an end result of the project, and to a shared workflow for the project.

The party uses the access rights to obtain (step 501) task related information of the one or more other parties, as described with Figure 2, for example. An internal workflow (a local workflow) may then be generated in step 502 using the information of the task the party has and information in the task related information obtained using the access rights information. The thus generated internal workflow, comprising at least the task and one or more dependent tasks, i.e. at least one dependent task, may be shown in step 503 to a user.

The obtaining of the task related information of the one or more other parties may be performed in response to a command or a user input to display the internal workflow, or the obtaining may be performed as a background operation, for example at certain time intervals or upon receiving a notification that there is something new to obtain, or the obtaining may be part of cloud storage functionality.

Referring to Figure 6, it is assumed, as in Figure 5, that the party operates (step 600) as a party responsible for a task in a project, and maintains the task related information, for example. In the illustrated example, when a task is completed, or more precisely a piece of work of the task is completed, end result information of the completed task (completed piece of work) is determined in step 601, and the end result information is added in step 602 to the task related information of the task. Hence, the parties of the dependent tasks will be made aware of the end result. This may be useful especially for following task(s) (those task(s) whose related work can be started after the task has been completed). For example, the end result information may indicate the actual, measured dimensions of a beam or a column. The end result information may indicate at least a difference between a result of the piece of work and a target result of the piece of work. For example, the end result information may indicate that a beam is 2 cm longer than the target, or that a floor is 6 cm higher in the middle than in outer edges, and the target was a flat floor. Such information can be used also in detailing of a wall that should be located above the floor, positioned to go from an outer edge to the middle, for example.

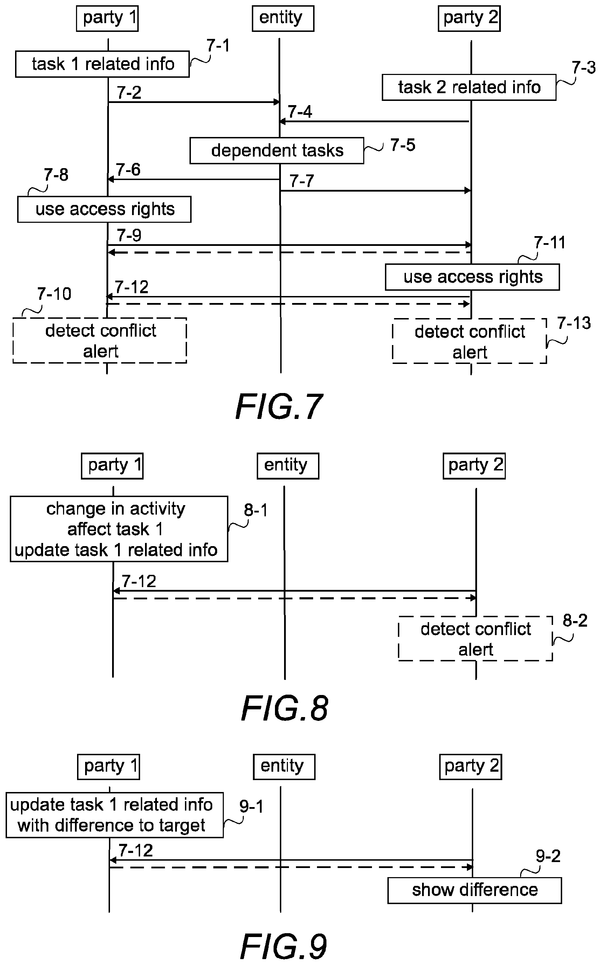

Figures 7 to 11 illustrate different examples of information sharing, between two parties of a project, for the sake of clarity. It should be appreciated that a project may have much more responsible parties. It is a straightforward process for one skilled in the art to implement the examples to a plurality of parties. Further, it should be appreciated that even though not separately illustrated, task related information may be shared or updated in a non-real time manner. In other words, the planning phase may comprise several phases and only when the plan relating to a task is considered as finished, or ready for sharing, the task related information may be shared. For example, a user may try different alternatives, or end her/his working day by storing a semi-finished plan, and sharing such, possibly temporary, information to other parties may cause confusion. Hence, in the examples below, task related information that is shared/updated is assumed to be ready for sharing, and the intermediate internal information storing is not discussed.

Referring to Figure 7, it is assumed that no task related information of tasks 1 and 2 exists. When the party 1 creates, in step 7-1, task related information of task 1, it shares (message 7-2) information required for access rights to the task 1 related information with the entity. The information (message 7-2) may comprise a memory address of the task related information or a pointer to the task related information. Correspondingly, when the party 2 creates, in step 7-3, task related information of task 2, it shares (message 7-4) information required for access rights to the task 2 related information with the entity. The entity determines in step 7-5 dependent tasks of the task 1 and the task 2, for example as described above with Figures 3 and 4, and provides corresponding access rights. In the illustrated example, the task 2 is a dependent task of the task 1, and the task 1 is a dependent task of the task 2. In the example of Figure 7, the party 1 is provided (message 7-6) with access rights to task 2 related information and the party 2 is provided (message 7-7) with access rights to task 1 related information.

The party 1 uses (step 7-8) the access rights and accesses (obtains, or retrieves, or reads), as illustrated by information exchange 7-9, the task 2 related information, and in case there is a conflict with timing and/or with a shared resource and/or location related information with the task 1, the conflict is detected in step 7-10 and the party 1 may be notified correspondingly. For example, an alert may be generated to notify the conflict. In a similar manner, perhaps even simultaneously, the party 2 uses (step 7-11) the access rights and accesses, as illustrated by information exchange 7-12, the task 1 related information, and in case there is the conflict with the task 2, the conflict is detected in step 7-13 and the party 2 may also be notified (alerted) correspondingly. Hence, both parties will be aware of the conflict, and the parties may discuss how to resolve the conflict.

Figure 8 illustrates an example of an information exchange which may happen after the information exchange in Figure 7, when the access rights are in use.

Referring to Figure 8, the party 1 is maintaining planning information of a plurality of activities to be performed, said activities comprising at least a first activity relating at least to the task 1. When the first activity is changed (step 8-1) with a change/update that affects (step 8-1) to at least one of timing related information, location related information and/or resource related information of the first activity, and thereby also affects the task 1 correspondingly, the task 1 related information is updated (8-1) to contain the changed information. Since the party 2 has access (information exchange 7-12) to the task 1 related information, it receives the change information. In the illustrated example it is assumed that the change does not cause a conflict within the tasks 1 and 2. Should the change cause such a conflict, it may be detected by both parties and corresponding alert(s) generated. However, it may be that the change causes a conflict within activities of the party 2, which activities may relate to other projects, not involving, for example, the party 1. If such a conflict is detected (step 8-2), the party 2 may be notified/alerted (step 8-2) correspondingly. Then the party 2 may contact the party 1 to solve the conflict, or try other ways to solve the conflict.

It should be appreciated that the change in step 8-1 may be a solution to a conflict detected in Figure 7.

Referring to Figure 9, when the party 1 has completed the task 1, the task 1 related information is updated, in the illustrated example, in step 9-1 with result information indicating a difference of the end result of the task 1 to the target result of the task 1, for example as described with Figure 6. Since the party 2 has access (information exchange 7-12) to the task 1 related information, it receives the result information, and may show in step 9-2 the difference. Hence, the information is easily available for further use.

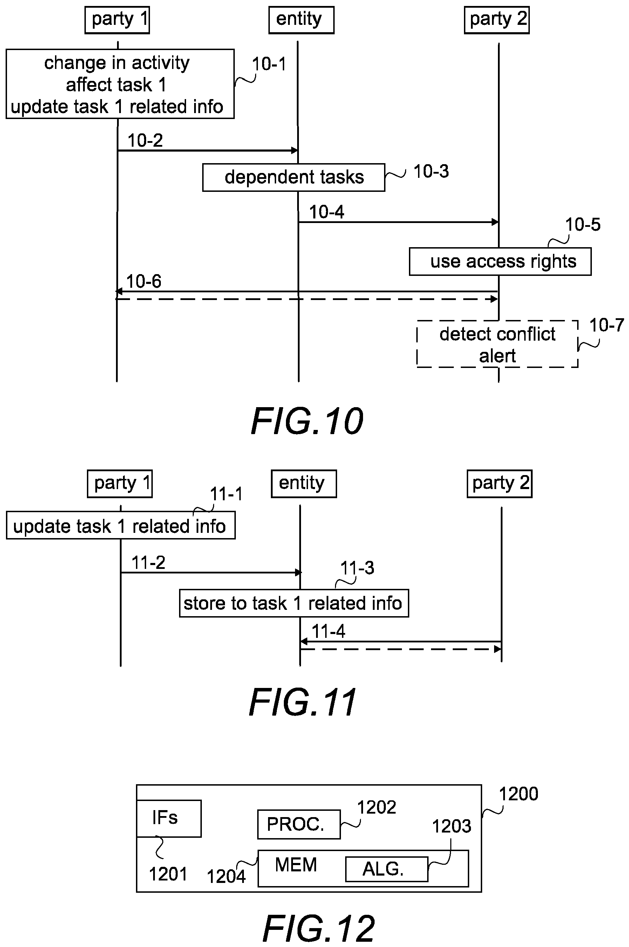

Figure 10 illustrates an example of information sharing in a similar situation as in Figure 8 but in the example of Figure 10 the parties access task related information when notified.

Referring to Figure 10, the party 1 is maintaining planning information of a plurality of activities to be performed, said activities comprising at least a first activity relating at least to the task 1. When the first activity is changed (step 10-1) with a change/update that affects (step 10-1) to at least one of timing related information, location related information and resource related information of the first activity, and thereby also affects the task 1 correspondingly, the task 1 related information is updated (10-1) to contain the changed information. Further, the party 1 informs (message 10-2) the entity that task 1 related information is updated (has changed). In other words, the entity may receive a change notification (message 10-2) comprising at least a task identifier of the task 1. If a plurality of tasks of the party 1 are affected the change notification may comprise, per a task, a task identifier.

The entity determines in step 10-3 dependent tasks of the task 1, and notifies responsible parties correspondingly. In the illustrated example, the party 2, responsible party of the task 2, is notified (message 10-4). The notification may comprise the task identifier of the task 1 and/or access rights to the updated task 1 related information.

Upon receiving the notification, the party 2 uses in step 10-5 the access rights, maintained by the party 2 and/or received in the notification, and accesses (information exchange 10-6) the task 1 related information (the updated task 1 related information). Then, in the example of Figure 10, as in the example of Figure 8, it may be that a conflict within activities of the party 2, which activities may relate to other projects, not involving, for example, the party 1, may detected (step 10-7), and the party 2 may be notified/alerted (step 10-7) correspondingly. Naturally both parties may detect a conflict in the project and be notified.

Figure 11 illustrates an example in which at least the party 1 is sharing the task 1 related information by transmitting (sending) a copy, or a snippet, of the task 1 related information to the entity. In the illustrated example of Figure 11, it is assumed that both parties have access rights to other parties task related information.

Referring to Figure 11, when the party 1 updates (step 11-1) its task 1 related information, it transmits (message 11-2) a copy of the task 1 related information, or a copy of the updated piece of the task 1 related information, to the entity. The entity is configured to store (step 11-2), the received copy to the task 1 related information. Since the party 2 has access (information exchange 11-4) to the task 1 related information in the entity, it receives the copied information, and may for example detect possible conflicts.

As can be seen from the above examples, it is possible to increase productivity in industry in which multiple parties (stakeholders) are involved in a project to produce an end result and in which the parties between different projects may vary from project to project and the parties can be involved at the same time with different, independent projects. An example of such an industry is a construction industry. The disclosed examples enable the parties to digitally and automatically share pieces of data which have direct connection with other parties' tasks, thereby enabling the parties to keep other pieces of data as secret data, while allowing the parties to have a digital local up-to-date view of the workflow situation.

Further, the disclosed examples provide upfront task planning, not necessitating use of the same application or a pre-agreed data format.

The steps, related functions and information sharing described above using Figures 1 to 11 are in no absolute chronological order, and some of the steps/functions and information sharing may be performed simultaneously or in an order differing from the given one. Other functions can also be executed between the steps or within the steps and/or other information may be shared. For example, a party sharing task related information may receive information indicating parties to whom access rights to the task related information are given. In another example, in response to detecting a change in the dependency information of one or more task, the process of providing access rights, for example as described with Figure 3, may be repeated per a task whose dependency information has been changed. Some of the steps or part of the steps can also be left out or replaced by a corresponding step or part of the step.

The techniques and methods described herein may be implemented by various means so that an apparatus/equipment/a device configured to provide the sharing unit of a party, and/or to provide access rights, and/or to maintain the shared information according to at least partly on what is disclosed above with any of Figures 1 to 11, including implementing one or more functions/operations described above with an embodiment/example, for example by means of any of Figures 1 to 11, comprises not only prior art means, but also means for implementing the one or more functions/operations of a corresponding functionality described with an embodiment/example, for example by means of any of Figures 1 to 11, and the apparatus may comprise separate means for each separate function/operation, or means may be configured to perform two or more functions/operations. Apparatuses (devices, equipments) may generally include one or more processors, controllers, control units, micro-controllers, or the like connected to one or more memories and to various interfaces of the apparatus, configured to implement the the sharing unit, and/or to provide access rights, and/or to maintain the shared information. For example, one or more of the means and/or any functionality described above may be implemented in hardware (one or more devices), firmware (one or more devices), software (one or more modules), or combinations thereof.

Figure 12 is a simplified block diagram illustrating some units for an apparatus 1200 configured to provide at least part of the functionality described above with Figures 1 to 11, comprising at least the sharing unit or being configured to act at least as the access rights provider.

Referring to Figure 12, the apparatus 1200 comprises one or more interfaces (IFs) 1201, for example, for retrieving (obtaining), for example, shared information and task related information whereto access rights are given or for providing access rights. The one or more interfaces may comprise one or more user interfaces for user interaction. The apparatus 1200 further comprises one or more processors 1202 configured to implement at least part of the functionality described above with Figures 1 to 11, with corresponding algorithms 1203, and one or more memories 1204 usable for storing a computer program code required for the functionality of the apparatus. The computer program code may include the one or more planning tools, i.e. the algorithms for implementing the functionality of a corresponding party. The memory 1204 is also usable for storing other information, such as access rights related information and/or the planning information.

Generally a processor 1202 is a central processing unit, but the processor may be an additional operation processor. The algorithms described herein for sharing information may be configured as a computer or a processor, or a multi-core processor or a microprocessor, such as a single-chip computer element, or as a chipset, including at least a memory for providing storage area used for arithmetic operation and an operation processor for executing the arithmetic operation. The one or more processors may comprise one or more computer processors, application-specific integrated circuits (ASIC), digital signal processors (DSP), programmable logic devices (PLD), field-programmable gate arrays (FPGA), graphics processing units (GPUs), logic gates and/or other hardware components that have been programmed and/or will be programmed by downloading computer program code (one or more algorithms) in such a way to carry out one or more functions described above. An embodiment provides a computer program embodied on any client-readable distribution/data storage medium or memory unit(s) or article(s) of manufacture, comprising program instructions executable by one or more processors/computers, which instructions, when loaded into an apparatus/device, constitute the access rights provider functionality or the sharing unit, or a plugin, for example, to an existing planning tool or a data sharing tool. Programs, also called program products, including software routines, program snippets constituting "program libraries", applets and macros, can be stored in any medium and may be downloaded into an apparatus. In other words, each or some or one of the functionalities and/or the algorithms described above may be an element that comprises one or more arithmetic logic units, a number of special registers and control circuits.

The memory 1204 may generally include volatile and/or non-volatile memory, for example flash memory, EEPROM, ROM, PROM, RAM, DRAM, SRAM, SGRAM, double floating-gate field effect transistor, firmware, programmable logic, read-mostly memory, write-only memory, etc. and typically store content, data, or the like. In other words, the one or more memories 1204 may be of any type (different from each other), have any possible storage structure and, if required, being managed by any database management system. It is to be noted that the memory, or part of it, may be any computer-usable non-transitory medium within the processor/apparatus or external to the processor/apparatus, in which case it can be communicatively coupled to the processor/apparatus via various means as is known in the art. Examples of an external memory include a removable memory detachably connected to the apparatus, a distributed database and a cloud. The memory may also store computer program code such as software applications (for example, for one or more of the functionalities) or operating systems, information, data, content, or the like for the processor to perform steps associated with operation of the apparatus in accordance with examples/embodiments.

It will be obvious to a person skilled in the art that, as the technology advances, the inventive concept can be implemented in various ways. The invention and its embodiments are not limited to the examples described above but may vary within the scope of the claims.

## Claims

1. A computer implemented method for sharing task related information between different parties of a construction project, the method comprising:
maintaining (300, 400), for the construction project, at least shared model information (112-1) of an end result of the construction project, shared information (112-2) of responsible parties involved, and a shared workflow (112-3), wherein
the shared model information (112-1) comprises at least, per a part, a part identifier, which is unique within the construction project, said part representing a piece for the end result of the construction project in a model of the end result;
the shared workflow (112-3) comprises a plurality of tasks,
a task representing a piece of work to be done or undertaken for the construction project, the task having a task identifier, which is unique within the construction project, and comprising at least an indication of a party responsible for the task, and dependency information indicating one or more dependent tasks, a dependent task being either a preceding task or a following task,
wherein the tasks are in the shared workflow in an order in which a preceding task has to be completed before the piece of work the task represents can start, and
wherein the shared workflow associates tasks, per a task, at least with one of a part identifier, a shared resource in the construction project and a shared location; and
providing (301), per a pair of a first task and a dependent task of the first task, a responsible party of the dependent task with access rights (123-1) to task related information of a responsible party of the first task; and
providing (301), per the pair of a first task and the dependent task, the responsible party of the first task with access rights to task related information (123-2) of the responsible party of the dependent task.

2. The computer implemented method of claim 1, wherein the task related information (123-2) comprises at least one of timing related information, location related information and shared resource related information, wherein the location related information of a task defines at least one of a space defined based on a physical size of a part associated with the task or the space defined based on the physical size added with extra space required for the work to be performed.

3. The computer implemented method of claim 1 or 2, wherein the task related information (123-2) comprises end result information of the piece of work.

4. The computer implemented method of any preceding claim, further comprising:
receiving (7-4) a change notification for a second task from a second party, the change notification comprising at least a task identifier;
determining (7-5) one or more dependent tasks of the second task; and
providing (7-9), per a dependent task, a responsible party of the dependent task with indication of a change in the second task.

5. The computer implemented method of any preceding claim, further comprising:
adding (401), by a third party, a new task to the shared workflow, the new task being associated with at least one of a part identifier, a shared resource in the construction project and a shared location;
assigning (402) to the new task a unique task identifier;
determining (403), using information of the third party, information associated with the new task, the shared model information, the shared information of responsible parties involved and the shared workflow, one or more dependent tasks to the new task;
providing (404), per a pair of the new task and a dependent task of the new task, a responsible party of the dependent task with access rights to task related information of the new task; and
providing (404), per the pair of the new task and the dependent task, the third party with access rights to task related information of the responsible party of the dependent task.

6. A computer implemented method for sharing task related information between parties of a construction project, the method comprising:
having (7-8, 7-11) access at least to shared model information (112-1) of an end result of the construction project, and a shared workflow (112-3) for the construction project, wherein
the shared model information (112-1) comprises at least, per a part, a part identifier, which is unique within the construction project, said part representing a piece for the end result of the construction project in a model of the end result,
the shared workflow (112-3) comprises a plurality of tasks,
a task representing a piece of work to be done or undertaken for the construction project, the task having a task identifier, which is unique within the construction project, and comprising at least an indication of a party responsible for the task, and dependency information indicating one or more dependent tasks, a dependent task being either a preceding task or a following task,
wherein the tasks are in the shared workflow in an order in which a preceding task has to be completed before the piece of work the task represents can start,
and wherein the shared workflow associates task, per a task, at least with one of a part identifier, a shared resource in the construction project and a shared location;
operating as a first party responsible for one or more first tasks in the construction project;
maintaining (7-1), per a first task, first task related information, accessible by parties of the construction project to which an entity maintaining the shared model information and the shared workflow provides access rights; and
maintaining (7-8) access rights information to at least second task related information of a second party of a second task, said access rights being provided by the entity.

7. The computer implemented method of claim 6, further comprising:
accessing (7-9, 7-12) the second task related information of the second task using the access rights information;
detecting (7-10, 7-13) a conflict between the second task related information and at least one of the first task related information; and
generating (7-10, 7-13) an alert notifying the conflict.

8. The computer implemented method of claim 6 or 7, wherein task related information (7-1) comprises at least one of timing related information, location related information and resource related information.

9. The computer implemented method of claim 8, further comprising:
maintaining planning information of a plurality of activities to be performed, said activities comprising at least a first activity relating at least to one of the first tasks;
updating, in response to detecting in at least one activity of the plurality of activities a change that affects to at least one of timing related information, location related information and resource related information of said first activity, task related information of said at least one of the first tasks correspondingly.

10. The computer implemented method of claim 9, further comprising:
accessing (7-9, 7-12), after updating the task related information of said at least one of the first tasks, the second task related information of the second task using the access rights information;
detecting (7-10, 7-13) a conflict between the second task related information and updated task related information of said at least one of the first tasks; and
generating an alert notifying the conflict.

11. The computer implemented method of any of claims 6 to 10, further comprising:
determining (601), in response to completing a piece of work of one of the first tasks, end result information of the piece of work; and
updating task related information of the one of the first tasks by adding (602) the end result information to the task related information of the one of the first tasks.

12. The computer implemented method of claim 9, 10 or 11, further comprising:
providing (7-12), in response to the updating, the entity with a change notification comprising, per a first task in the at least one of the first tasks, at least a task identifier of the first task.

13. The computer implemented method of any of claims 6 to 12, further comprising:
generating (502) an internal workflow (220) using the one or more first tasks (220-1) and information (220a-2, 220b-2, 220c-2) obtained using the access rights information; and
showing (503) the internal workflow (220) comprising the one or more first task and the at least one second task.

14. A computer program product comprising program instructions (1203) which, when the program is executed by a computing device (1200), cause the computing device (1200) to carry out the method of any of claims 1 to 5 or the method of any of claims 6 to 13.

15. An apparatus (110, 120, 1200) comprising means (111, 112, 121, 123, 1201, 1202, 1204) for implementing the method of any of claims 1 to 5 or the method of any of claims 6 to 13.
